# EUROPEAN PATENT APPLICATION

(11) **EP 4 530 871 A1**
(43) Date of publication of application: **02.04.2025**
(21) Application number: 23856169.0
(22) Date of filing: 01.06.2023
(51) Int. Cl.: G06F 13/42

(54) **SERVER AND DATA CENTER**

(30) Priority: 24.08.2022 CN 202211019373
(71) Applicant: xFusion Digital Technologies Co., Ltd., Zhengzhou, Henan 450000 (CN); Xiamen Chuangpuyun Technology Co., Ltd., Xiamen, Fujian 361001 (CN)
(72) Inventor: QI, Yanjun, Zhengzhou, Henan 450000 (CN); LIN, Bingfan, Xiamen, Fujian 361001 (CN)
(74) Representative: MERH-IP Matias Erny Reichl Hoffmann Patentanwälte PartG mbB
(86) International application number: PCT/CN2023/097797
(87) International publication number: WO 2024/041077

(57) **Abstract**

Embodiments of this application disclose a server and a data center. The server provided in the embodiments of this application includes a chassis and a plurality of PCIe cards. An internal space of the chassis includes a first space and a second space that are arranged in a height direction, the first space is located above the second space, the PCIe cards are located in the second space, at least one of the PCIe cards has an interface facing the first space, the interface of the PCIe card is configured to connect to a power supply wire, the first space is configured to accommodate the power supply wire, a height of the second space is greater than or equal to 3U, and a height of the chassis is greater than or equal to 4U. The server provided in the embodiments of this application can support a top-powered PCIe card, has strong adaptability to PCIe cards, and can support a plurality of PCIe cards.

## Description

This application claims priority to Chinese Patent Application No. 202211019373.4, filed with the China National Intellectual Property Administration on August 24, 2022 and entitled "SERVER AND DATA CENTER", which is incorporated herein by reference in its entirety.

### TECHNICAL FIELD

This application relates to the field of server technologies, and in particular, to a server and a data center.

### BACKGROUND

An existing server space layout is unreasonable. A PCIe card is connected to a mainboard through a riser card, and the riser card occupies a lower 1U space. Consequently, the PCIe card can only be configured in an upper 3U space. A power supply interface of a top-powered PCIe card faces upward, and wires need to be routed above the PCIe card. Since the PCIe card itself occupies the upper 3U space, there is no extra upper space to accommodate the interface of the PCIe card and a power supply wire connected to the interface. As a result, the server cannot support top-powered PCIe cards.

### SUMMARY

An objective of embodiments of this application is to provide a server and a data center. The server provided in the embodiments of this application can support a top-powered PCIe card, and has strong adaptability to PCIe cards.

According to a first aspect, an embodiment of this application provides a server. The server provided in this embodiment of this application includes a chassis and a plurality of PCIe cards. An internal space of the chassis includes a first space and a second space that are arranged in a height direction, the first space is located above the second space, the PCIe cards are located in the second space, at least one of the PCIe cards has an interface facing the first space, the interface of the PCIe card is configured to connect to a power supply wire, the first space is configured to accommodate the power supply wire, a height of the second space is greater than or equal to 3U, and a height of the chassis is greater than or equal to 4U.

In this embodiment of this application, the first space of the chassis is located above the second space. The second space is used to accommodate the PCIe card, the PCIe card has an interface facing the first space, and the interface of the PCIe card is configured to connect to the power supply wire, that is, the PCIe card uses a top-powered manner. The first space is used to accommodate the power supply wire, so that the server can support a top-powered PCIe card, and has strong adaptability to the PCIe card.

In addition, the height of the second space is greater than or equal to 3U, that is, is greater than or equal to 133.35 mm, and an FHHL PCIe card (the height is less than or equal to 111.15 mm) and an FHFL PCIe card (the height is less than or equal to 111.15 mm) can be supported; and an HHHL PCIe card (the height is less than or equal to 68.9 mm) and an HHFL PCIe card (the height is less than or equal to 68.9 mm) can be supported. Therefore, the server provided in this embodiment of this application can support a plurality of PCIe cards, and has strong adaptability to PCIe cards.

In some implementations, the interface of the PCIe card protrudes from an upper surface of the PCIe card and extends into the first space.

In this implementation, the interface of the PCIe card may be located on the upper surface, or may protrude relative to the upper surface. The first space can further accommodate the interface protruding from the upper surface of the PCIe card, so that the server can support not only the PCIe card whose interface is on the upper surface, but also the PCIe card whose interface protrudes from the upper surface, thereby further improving a capability of the server to adapt to PCIe cards.

In some implementations, the server further includes a mainboard, the mainboard is fastened to a bottom panel of the chassis, and the PCIe card is inserted on the mainboard.

In this implementation, because at least a partial structure of the mainboard is in contact with the bottom panel of the chassis, a large height space is reserved for a first area, so that the height of the first area can be equal to the height of the chassis.

In some implementations, there are at least 17 slots in a width direction of the second space, and the PCIe card occupies at least one slot.

In this implementation, the server provided in this embodiment of this application can support 17 PCIe cards, and has strong computing power density.

In some implementations, there are at most 19 slots in the width direction of the first area.

In this implementation, the server provided in this embodiment of this application can support 19 PCIe cards, and has strong computing power density.

In some implementations, the plurality of PCIe cards include at least eight FHFL double-width GPU cards, and each FHFL double-width GPU card occupies two of the slots.

In this implementation, the server includes at least eight FHFL double-width GPU cards, and has strong computing power density, so that a service scenario such as AI training and/or reasoning, HPC, and graphics rendering can be met.

In some implementations, the server further includes a power supply unit, the internal space of the chassis further includes a third space, the third space is parallel to the second space in a horizontal direction, and the power supply unit is located in the third space.

In this implementation, the power supply unit is connected to the mainboard, and is configured to supply power to the mainboard. In addition, the third space and the second space are parallel in the horizontal direction, and do not occupy the height space of the second space and the first space, so that the height of the first space and the height of the second space are equal to the height of the chassis.

In some implementations, the third space is located on a left side or a right side of the second space. Or the second space has at least two subspaces, and the third space is located between two of the subspaces.

In some implementations, the server further includes a first adapter board, and there are a plurality of power supply units. The plurality of power supply units are arranged side by side in the height direction of the chassis and connected to the mainboard through the first adapter board.

In this implementation, the plurality of power supply units can be arranged in the height direction of the chassis by disposing the first adapter board, so that occupation by the plurality of power supply units in the width direction of the chassis is reduced, and more space is reserved for the second space in the width direction. In this way, the second space may have a larger width, and therefore more PCIe cards can be accommodated, thereby improving computing power density of the server.

In some implementations, the server further includes an I/O interface, and the internal space of the chassis further includes a fourth space, the fourth space is parallel to the second space in the horizontal direction, and the I/O interface is located in the fourth space.

In this implementation, the I/O interface is configured to connect to an external device of the server, so as to implement data transmission between the external device and the server. In addition, the third space and the second space are parallel in the horizontal direction, and do not occupy the height space of the second space and the first space, so that the height of the first space and the height of the second space are equal to the height of the chassis.

In some implementations, the server further includes a second adapter board, and there are a plurality of I/O interfaces; and the plurality of I/O interfaces are arranged side by side in the height direction of the chassis, and are connected to the mainboard through the second adapter board.

In this implementation, the plurality of I/O interfaces can be arranged in the height direction of the chassis by disposing the second adapter board, so that occupation by the plurality of I/O interfaces in the width direction of the chassis is reduced, and more space is reserved for the second space in the width direction. In this way, the second space may have a larger width, and therefore more PCIe cards can be accommodated, thereby improving computing power density of the server.

According to a second aspect, an embodiment of this application further provides a data center. The data center provided in this embodiment of this application includes a plurality of servers.

In this embodiment of this application, the server can support a top-powered PCIe card, and has strong adaptability to PCIe cards.

### BRIEF DESCRIPTION OF DRAWINGS

FIG. 1 is a schematic diagram of a structure of a server in some embodiments according to an embodiment of this application;
FIG. 2 is a schematic diagram of an internal structure of the server shown in FIG. 1 in some embodiments;
FIG. 3 is a schematic diagram of regional distribution of a rear panel shown in FIG. 1;
FIG. 4 is a schematic diagram of regional distribution of the rear panel shown in FIG. 3 in some other embodiments;
FIG. 5 is a schematic diagram of regional distribution of the rear panel shown in FIG. 3 in still other embodiments;
FIG. 6 is a schematic diagram of regional distribution of a first space and a second space corresponding to a first area shown in FIG. 3 in a height direction;
FIG. 7 is a schematic diagram of regional distribution of a first space and a second space corresponding to a first area shown in FIG. 3 in a width direction;
FIG. 8 is a schematic exploded view of a partial structure of the server shown in FIG. 2;
FIG. 9 is a schematic diagram of the partial structure shown in FIG. 8 in an assembled state;
FIG. 10 is a schematic exploded view of a partial structure shown in FIG. 1;
FIG. 11 is a schematic structural diagram of the structure shown in FIG. 10 from another perspective; and
FIG. 12 is a schematic diagram of a logical topology of the server shown in FIG. 1 in some embodiments.

### DESCRIPTION OF EMBODIMENTS

For ease of understanding, the following first explains and describes English abbreviations and related technical terms used in embodiments of this application.

Data center: A data center is a globally collaborative network of specific devices used to transfer, accelerate, display, calculate, and store data information on the Internet infrastructure. The data center includes a plurality of servers.

Server (server): A server is a high-performance computer that runs corresponding application software in a network environment, provides shared information resources and various services for online users, and provides various shared services and other applications for terminal users. The server may include a central processing unit, a memory, a hard disk, various buses, and the like, and has a high-speed computing capability, long-term reliability, and a powerful external data throughput capability.

Workstation (workstation): A workstation is a high-performance computer that is based on personal computers and distributed network computing, is oriented towards professional application fields, has powerful data calculation, graphics and image processing capabilities, and is designed and developed to meet the needs of professional fields such as engineering design, animation production, scientific research, software development, financial management, information services, and simulation.

A mainboard may also be referred to as a main board (main board), a system board (system board), or a mother board (mother board). Components in the server are connected to each other through the mainboard, and the mainboard is used to transmit various electronic signals and preliminarily process some peripheral data.

BIOS (basic input output system, basic input output system) chip: A BIOS chip carries a basic input/output program of a computer, a power-on self-test program, and a system self-start program, and can provide the most foundational and direct hardware configuration and control for the computer. The BIOS chip can further provide some system parameters to the job system.

CPU (central processing unit, central processing unit): A CPU is an operation and control core of an information processing system, and is an execution unit of information processing and program running.

DIMM (dual inline memory module, dual inline memory module): A DIMM is a memory module. A memory module is configured to provide a running space of an information processing system and software, and is further configured to temporarily store operation data in a CPU and data exchanged with an external memory such as a hard disk. The CPU may address the memory through a data bus, and perform a read/write operation on the memory.

PCH (platform controller hub, platform controller hub): APCH may also be referred to as a southbridge chip. The southbridge chip is configured to process a low-speed signal, and communicates with the CPU through a northbridge chip. The northbridge chip is disposed near the CPU, and is mainly responsible for controlling data exchange between an AGP (accelerated graphics port, accelerated graphics port) graphics card, a memory, and the CPU. The southbridge chip is disposed near a PCI (peripheral component interconnect, peripheral component interconnect) slot, and is mainly responsible for data exchange of a floppy drive, a hard disk, a keyboard, and an additional card. The southbridge chip and the northbridge chip are connected through a PCI bus to form a mainboard chip group architecture.

BMC (baseboard management controller, baseboard management controller): A BMC is configured to perform operations such as upgrading firmware on the machine and checking a machine device when the machine is not powered on.

A management-type signal, such as an IPMI (intelligent platform management interface, intelligent platform management interface) signal, a USB (universal serial bus, universal serial bus) signal, and a VGA (video graphics array, video graphics array) signal, is transmitted between the BMC and the PCH. The BMC and the PCH can implement functions such as power-on/off, log acquisition, image display, and virtual media.

PCIe (peripheral component interconnect express, peripheral component interconnect express): PCIe is a high-speed serial computer expansion bus standard used to implement high-speed serial point-to-point, dual-channel, and high-bandwidth transmission. The PCIe mainly supports the active power management, error report, end-to-end reliability transmission and hot swap. The PCIe is a multi-layer protocol involving a session layer, a data exchange layer, and a physical layer.

PCIe card: A PCIe card is a card that complies with the PCIe standard. A physical size of the PCIe card may be described by using FHHL (half height half length, half height half length), FHHL (full height half length, full height half length), and FHFL (full height full length, full height full length). "Half length" indicates a length less than or equal to 167.65 mm; "full length" indicates a length less than or equal to 312.00 mm; "half height" indicates a height less than or equal to 68.9 mm; and "full height" indicates a height less than or equal to 111.15 mm.

Link: A link is a point-to-point communication channel between two PCIe ports, which may also be referred to as interconnection. The two PCIe ports communicate via a link.

PCIe SW (switch, switch): A PCIe SW provides expansion or aggregation capabilities and allows more devices to connect to a PCIe port. The PCIe SW serves as a packet router to identify which path a given packet needs to go based on an address or other routing information.

GPU (graphics processing unit, graphics processing unit): A GPU is a microprocessor configured to implement image and graphics related operations.

GPU card: A GPU card may also be referred to as a graphics card, and may include components such as a GPU, a graphics memory, a circuit board, BIOS firmware, and a heat sink.

IB (infiniband, infiniband): IB is a computer network communication standard for high-performance computing, has an extremely high throughput and an extremely low delay, and is used for data interconnection between computers. IB may also be used for communication between servers, between a server and a storage device (such as a direct storage attachment), and between a server and a network (such as a local area network, a wide area network, and the Internet).

IB card: An IB card is a card that complies with the IB standard.

Network adapter: A network adapter may be a component configured to implement communication between a server and a network.

RAID (redundant arrays of independent disks, redundant arrays of independent disks): RAID is a method for storing same data in different places of a plurality of hard disks. By placing data on a plurality of hard disks, I/O processing can overlap in a balanced manner to improve I/O performance, thereby improving data read efficiency and implementing redundancy protection for data.

RAID card: An RAID card is a component configured to implement the RAID method.

HBA (host bus adapter, host bus adapter): An HBA is a circuit board or an integrated circuit adapter configured to provide I/O processing and physical connection between a server and a storage apparatus.

Power supply unit (power supply unit, PSU): A PSU, which may also be referred to as a power supplier, is a power supply of an electrical energy conversion type (which is different from a power supply of a battery supply type), and is configured to: convert a standard alternating current into a low-voltage stable direct current, and provide the direct current for use by another component.

I/O (input/output, input/output): I/O generally refers to input and output of data between an internal information processing system of a server and an external device.

I/O interface: An I/O interface is used to connect an external device and the internal information processing system of the server.

Serial interface (serial interface): A serial interface, also referred to as a serial communication interface, is an extended interface in a serial communication manner.

Network interface: A network interface refers to various interfaces for connecting a network device to the Ethernet. Common network interfaces include an RJ (registered jack)-45 interface, an RJ-11 interface, an FC (ferrule connector) fiber connector, an SC (square connector) fiber interface, an ST (stab & twist) fiber interface, an FDDI (fiber distributed data interface, fiber distributed data interface), an AUI (attachment unit interface, attachment unit interface), a BNC (bayonet nut connector, bayonet nut connector) interface, and the like.

"U" is a unit representing an external dimension of a server, and is an abbreviation of unit. A specific dimension represented by 1U is determined by the electronic industries association (electronic industries association, EIA). 1U is 44.45 mm. 3U is 3 times 1U, that is, 133.35 mm. 4U is 4 times 1U, that is, 177.8 mm. It may be understood by a person skilled in the art that, in an actual manufacturing process, an actual dimension of "U" may be deviated, or a specific dimension of "U" may be determined by another optional server external dimension formulation department or organization, which is not limited herein.

Slot (slot): In embodiments of this application, a slot represents a space required for an element to be inserted into a socket.

AI (artificial intelligence, artificial intelligence): AI is a new technical science that studies and develops theories, methods, technologies, and application systems that are used to simulate, extend, and expand human intelligence.

HPC (high performance computing, high performance computing): HPC refers to a large amount of data and high-speed computing that a personal computer cannot handle.

The following describes the embodiments of this application with reference to the accompanying drawings in the embodiments of this application. In the descriptions of embodiments of this application, "a plurality of" means two or more than two unless otherwise specified. The terms "first", "second", and the like are merely intended for a purpose of description, and shall not be understood as an indication or implication of relative importance or implicit indication of the number of indicated technical features. Therefore, a feature defined as "first" or "second" may explicitly or implicitly include one or more of the features.

In addition, "connection" in this specification should be understood in a broad sense. For example, "connection" may be a removable connection, or may be a non-removable connection; may be direct connection, or may be indirect connection by using an intermediate medium. "Fasten" in this specification should also be understood in a broad sense. For example, "fasten" may be direct fastening, or may be indirect fastening by using an intermediate medium.

In addition, the orientational terms mentioned in embodiments of this application, for example, "front", "rear", "left", "right", "top", and "bottom", are merely directions described with reference to the accompanying drawings. Therefore, the orientational terms used are intended to enhance clarity and understanding of embodiments of this application, rather than to indicate or imply that the referred apparatus or element must have a specific orientation or be constructed and operated in a specific orientation, and therefore should not be understood as a limitation on embodiments of this application.

Embodiments of this application provide an ICT (information and communications technology, information and communications technology) product. The ICT product may refer to devices that bring people and organizations into the digital world, including switches, routers, network transport devices, servers, and the like. The ICT product may have a communication function to implement data transmission. The ICT product can further have data processing functions to analyze and process data.

In embodiments of this application, a server is used as an example for description.

Embodiments of this application further provide a data center. The data center may include a plurality of servers. For example, a plurality of servers may be communicatively connected to form a data center network for data transmission.

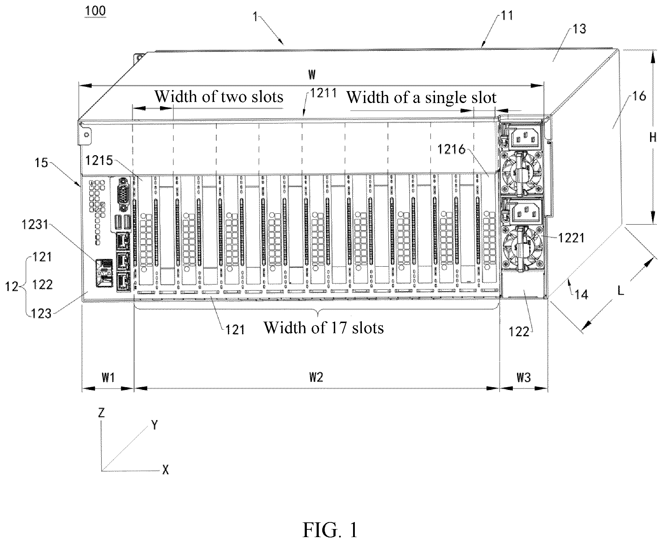

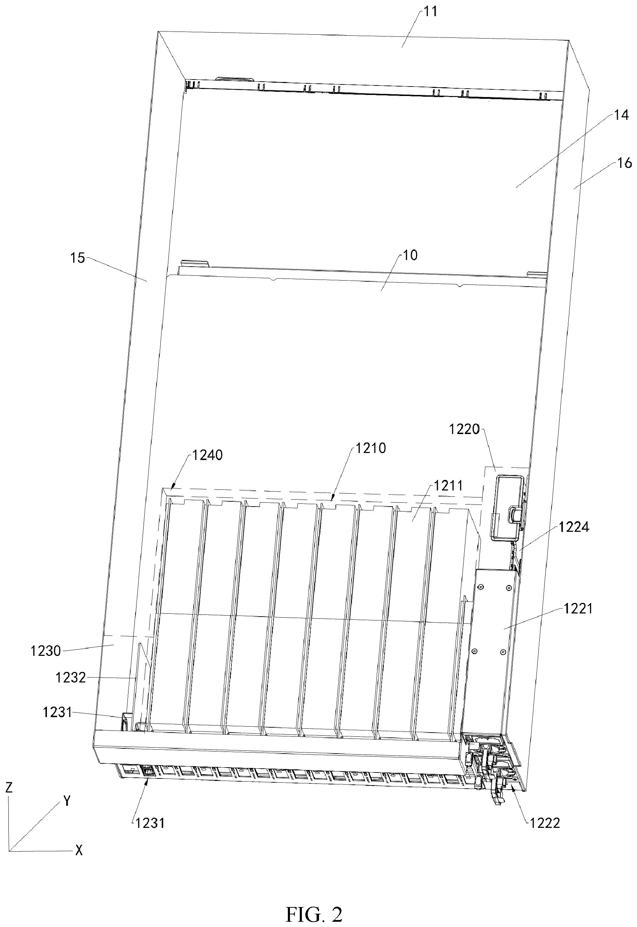

Refer to FIG. 1 and FIG. 2. FIG. 1 is a schematic diagram of a structure of a server 100 in some embodiments according to an embodiment of this application. FIG. 2 is a schematic diagram of an internal structure of the server 100 shown in FIG. 1 in some embodiments.

For example, the server 100 may include a cuboid-shaped chassis 1. The chassis 1 may include six side panels, and the six side panels may be a front panel 11 and a rear panel 12 that are disposed opposite to each other, and a top panel 13, a bottom panel 14, a left panel 15, and a right panel 16 that are connected between the front panel 11 and the rear panel 12. The top panel 13 is disposed opposite to the bottom panel 14, and the left panel 15 is disposed opposite to the right panel 16. The front panel 11, the rear panel 12, the top panel 13, the bottom panel 14, the left panel 15, and the right panel 16 jointly enclose an internal space of the chassis 1.

For example, one or more of the six side panels of the chassis 1 may use an integrated plate structure, or may use a panel structure formed by laminating and/or splicing a plurality of plates. Outer surfaces of the six side panels of the chassis 1 are surfaces of the six side panels facing an external power supply device of the chassis 1. An outer surface of one or more of the six side panels of the chassis 1 may be a plane, or may be provided with a convex structure and/or a groove structure, but is generally in a planar shape.

The chassis 1 has a height H, a width W, and a length L. The rear panel 12 is parallel to the height direction Z and the width direction X of the chassis 1. The bottom panel 14 is parallel to the width direction X and the length direction Y of the chassis 1. The height H of the chassis 1 is a distance between the outer surface of the top panel 13 of the chassis 1 and the outer surface of the bottom panel 14, the width W of the chassis 1 is a distance between the outer surface of the left panel 15 of the chassis 1 and the outer surface of the right panel 16, and the length L of the chassis 1 is a distance between the outer surface of the front panel 11 of the chassis 1 and the outer surface of the rear panel 12. It should be noted that a thickness of each of the six side panels of the chassis 1 is relatively thin, and can be ignored relative to a size of the chassis 1. That is, the height H, the width W, and the length L of the chassis 1 may be approximately considered as a height H, a width W, and a length L of the internal space of the chassis 1.

For example, as shown in FIG. 2, the server 100 may further include a mainboard 10 mounted in the internal space of the chassis 1 and functional components connected to the mainboard 10.

For example, the mainboard 10 is fixedly mounted on the bottom panel 14. A plane on which the mainboard 10 is located is parallel to the bottom panel 14 of the chassis 1. At least a partial structure of the mainboard is in contact with the bottom panel 14 of the chassis 1, so as to reduce a space between the mainboard 10 and the bottom panel 14, thereby reducing occupation of a height space of the chassis 1 by the mainboard 10, and leaving enough height space for the functional components.

For example, the mainboard 10 may be attached to the bottom panel 14 of the chassis 1, so that a space between the mainboard 10 and the bottom panel 14 is further reduced, and a larger height space is reserved for the functional components.

The mainboard 10 has a function of electrically connecting an electronic element and supporting. Each functional component in the server 100 is connected to the mainboard 10, and various electronic signals are transmitted through the mainboard 10, so as to implement communication connection. The mainboard 10 may be equipped with a circuit system. The circuit system may include one or more of elements such as a BIOS chip, an I/O control chip, a keyboard and panel control switch interface, an indicator connector, an expansion socket, and a direct current power supply connector for the mainboard 10 and an inserted card. The mainboard 10 may control a system memory, storage devices, and other I/O devices through the circuit system.

In some embodiments, the mainboard 10 may be a rigid substrate. For example, the rigid substrate may be a copper clad laminate (copper clad laminate, CCL), and the CCL may be a panel material formed by impregnating a reinforcing material with resin, coating one or both sides of the reinforced material with copper foil, and hot pressing. For example, the reinforcing material of the copper clad laminate may be paper, glass fiber, ceramic, silicon dioxide, boron nitride, metal, resin, composite materials, and the like. The material of the mainboard 10 may be selected based on requirements of a requirement specification, a high-speed signal, a flow-through capability, costs, and the like. This is not strictly limited in this embodiment of this application.

In some other embodiments, the mainboard 10 may alternatively be a flexible substrate. When the mainboard 10 is a flexible substrate, a rigid support may be provided for the flexible substrate by using a reinforcing panel. For example, the flexible substrate may be made of polyester material such as polyimide. The reinforcing panel may be metal, a high molecular material, an inorganic non-metal material, or the like. This is not strictly limited in this embodiment of this application.

The functional components may include components such as a CPU, a DIMM, a PCH, a BMC, a PCIe card, a PSU, and an I/O interface.

For example, the PCIe card may include a RAID card, a network adapter, an HBA, an IB card, a GPU card, or the like.

GPU cards may be classified into a data center GPU card, a workstation GPU card, and a consumer GPU card according to a type of an application terminal in which the GPU card is located. The data center GPU card, the workstation GPU card, and the consumer GPU card may be respectively applicable to application scenarios of a data center, a workstation, and a consumer electronic product. Because the application scenarios of the data center, the workstation, and the consumer electronic product have different requirements for image data processing, performance of GPU cards applied to the different application scenarios is also different. To meet different performance requirements, GPU cards applied to different application scenarios have different structures, and also have different requirements for a mounting space.

The server 100 may have more or fewer functional components than those described above, and may combine two or more functional components, or may have different functional component configurations. The various functional components may be implemented in hardware including one or more signal processing and/or application-specific integrated circuits, software, or a combination of hardware and software.

In this embodiment of this application, a plurality of functional components are mounted in the internal space of the chassis 1. By designing the mounting space, a quantity and types of functional components that can be supported by the server 100 can be changed, so that the server 100 obtains different performance. In embodiments of this application, the layout of the back-end space of the chassis 1 is described by way of example with reference to the accompanying drawings.

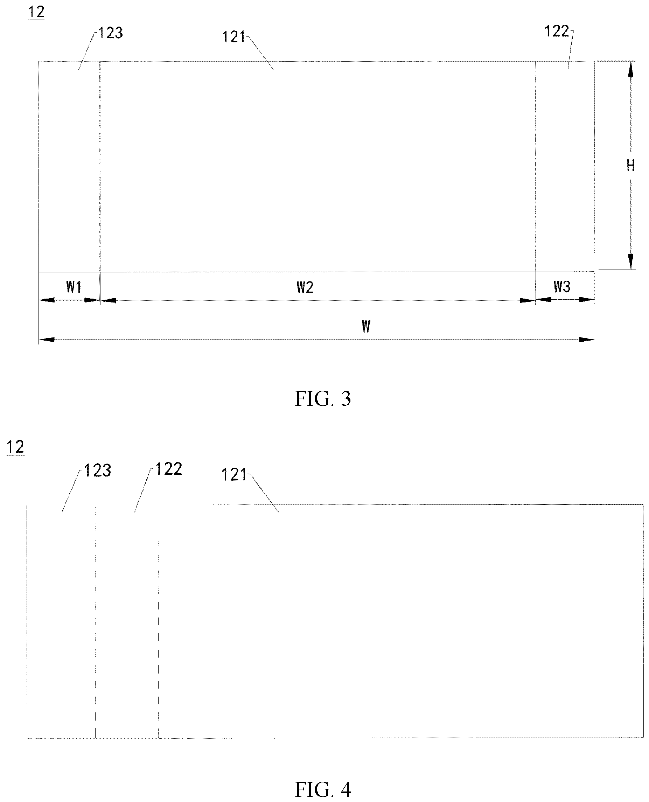

Refer to FIG. 1 and FIG. 3 in combination. FIG. 3 is a schematic diagram of regional distribution of the rear panel 12 shown in FIG. 1.

For example, the rear panel 12 of the server 100 may include a first area 121, a second area 122, and a third area 123, configured to support a plurality of PCIe cards 1211, a power supply unit 1221, and an I/O interface 1231 respectively.

For example, the width W2 of the first area 121 is greater than or equal to 70% of the width W of the chassis 1, and the height H of the first area 121 is equal to the height H of the chassis 1. The height H of the chassis 1 is greater than or equal to 4U, that is, greater than or equal to 177.8 mm.

In this embodiment of this application, the width W2 of the first area 121 is greater than or equal to 70% of the width W of the chassis 1, and occupies a large space, so that the first area 121 can accommodate a large quantity of PCIe cards 1211, thereby increasing power density of the server 100.

In addition, because the height H of the chassis 1 is greater than or equal to 177.8 mm, that is, the height H of the first area 121 is greater than or equal to 177.8 mm, an FHHL PCIe card (the height is less than or equal to 111.15 mm) and an FHFL PCIe card (the height is less than or equal to 111.15 mm) can be supported; and an HHHL PCIe card (the height is less than or equal to 68.9 mm) and an HHFL PCIe card (the height is less than or equal to 68.9 mm) can be supported. Therefore, the server 100 provided in this embodiment of this application can support a plurality of PCIe cards 1211.

In this embodiment of this application, the first area 121 has a height as large as possible to meet the space requirements of PCIe cards 1211 of different design styles; in addition, the width W2 of the first area 121 is large to accommodate a large quantity of PCIe cards 1211, so that the server 100 can support a plurality of different types of PCIe cards 1211. Different types of PCIe cards 1211 are applicable to different application scenarios, and a plurality of PCIe cards 1211 may be flexibly configured according to a requirement, so as to meet diversified application scenarios.

In addition, because at least a partial structure of the mainboard 10 is in contact with the bottom panel 14 of the chassis 1, a large height space is reserved for the first area 121, so that the height H of the first area 121 can be equal to the height H of the chassis 1.

In this embodiment of this application, that the height H of the chassis 1 is 4U is used as an example for description. Correspondingly, the height H of the first area 121 is also 4U.

For example, as shown in FIG. 2, the internal space of the chassis 1 includes a first space 1240 and a second space 1210, the first space 1240 is located above the second space 1210, and the first space 1240 and the second space 1210 are areas extended by the first area 121 from the rear panel 12 to an inner side of the chassis 1. In some optional embodiments, the internal space of the chassis 1 may further include a third space 1220. The third space 1220 is an area extended by the second area 122 from the rear panel 12 to the inner side of the chassis 1. In some optional embodiments, the internal space of the chassis 1 may further include a fourth space 1230. The fourth space 1230 is an area extended by the third area 123 from the rear panel 12 to the inner side of the chassis 1.

It may be understood by a person skilled in the art that the first space 1240 may be an upper side or upper space of the internal space of the chassis 1, the second space 1210 may be a lower side or lower space of the internal space of the chassis 1. In other words, the space that is in the internal space of the chassis 1 and that accommodates the PCle card 1211 is the second space 1210, the upper space of the second space 1210 is the first space 1240, and a power supply interface of the at least one PCle card 1211 faces upward, that is, faces the first space 1240, and the first space 1240 is configured to accommodate a power supply wire of the PCle card 1211.

Refer to FIG. 3 to FIG. 5. FIG. 4 is a schematic diagram of regional distribution of the rear panel 12 shown in FIG. 3 in some other embodiments. FIG. 4 is a schematic diagram of regional distribution of the rear panel 12 shown in FIG. 3 in still other embodiments.

For example, the first area 121 may be parallel to another area of the rear panel 12 in a horizontal direction. In this embodiment of this application, the horizontal direction is parallel to the width direction X. For example, the first area 121 may be parallel to the second area 122 and the third area 123 in the horizontal direction, that is, the third space 1220 is parallel to the second space 1210 corresponding to the first area 121 in the horizontal direction, and the fourth space 1230 is parallel to the second space 1210 corresponding to the first area 121 in the horizontal direction. In this embodiment, the third space 1220 and the fourth space 1230 do not occupy the height space of the second space 1210 and the first space 1240, so that the height of the second space 1210 and the height of the first space 1240 are equal to the height H of the chassis 1, and the first area 121 can fully use the height space of the chassis 1.

In some embodiments, as shown in FIG. 3, the third area 123 and the second area 122 may be respectively located on two sides of the first area 121, that is, the third space 1220 and the fourth space 1230 may be respectively located on two sides of the second space 1210. The third space 1220 may be located on a left side or a right side of the second space 1210.

In other embodiments, as shown in FIG. 4, the third area 123 and the second area 122 may alternatively be located on a same side of the first area 121, that is, the third space 1220 and the fourth space 1230 may alternatively be located on a same side of the second space 1210.

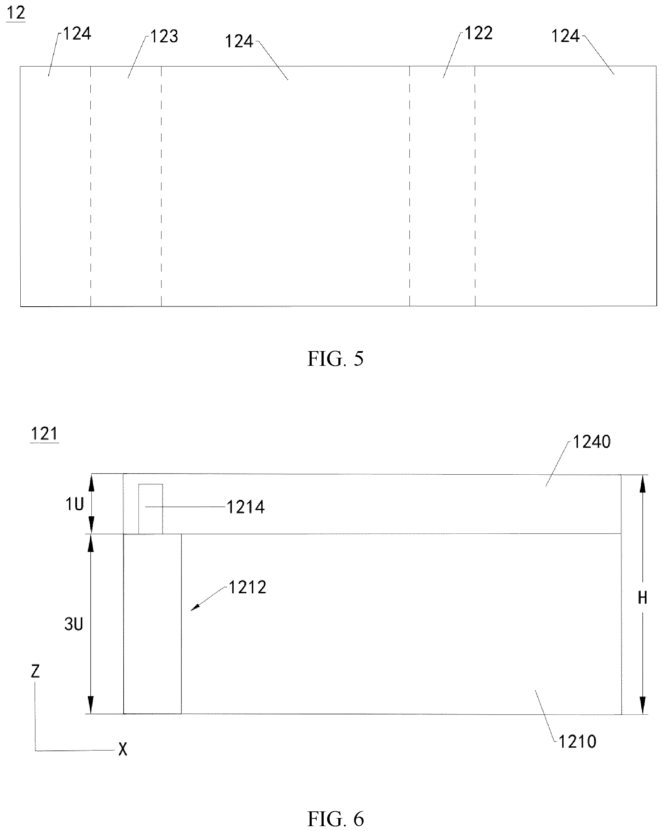

In still other embodiments, as shown in FIG. 5, the first area 121 may have at least two sub-areas 124, the second area 122 and/or the third area 123 may be located between two adjacent sub-areas 124. That is, the second space 1210 has at least two subspaces, and the third space 1220 and/or the fourth space 1230 may be located between two adjacent subspaces.

For example, the second area 122 and the third area 123 may be parallel in the horizontal direction, or may be stacked and distributed in the height direction Z of the chassis 1. That is, the third space 1220 and the fourth space 1230 may be parallel in the horizontal direction, or may be stacked and distributed in the height direction Z of the chassis 1. This is not limited in this embodiment of this application.

The following describes, by way of example with reference to the accompanying drawings, specific structures included in the first space 1240, the second space 1210, the third space 1220, and the fourth space 1230 that are corresponding to the first area 121, the second area 122, and the third area 123.

First, specific structures included in the first space 1240 and the second space 1210 that are corresponding to the first area 121 are described by way of example.

Refer to FIG. 2 and FIG. 6. FIG. 6 is a schematic diagram of regional distribution of the first space 1240 and the second space 1210 corresponding to the first area 121 shown in FIG. 3 in the height direction Z.

For example, as shown in FIG. 2, the height of the second space 1210 is greater than or equal to 3U, the height of the chassis 1 is greater than or equal to 4U, and the height of the first space 1240 and the height of the second space 1210 are equal to the height of the chassis 1. The server 100 may further include a plurality of PCIe cards 1211, and the plurality of PCIe cards 1211 are located in the second space 1210. The plurality of PCIe cards 1211 are arranged side by side in the width direction X of the chassis 1, and are inserted on the mainboard 10.

For example, the at least one PCIe card 1211 may have an interface 1214 facing the first space 1240, and the interface 1214 of the PCIe card 1211 is configured to connect to a power supply wire. The first space 1240 is configured to accommodate the power supply wire. The interface 1214 of the PCIe card 1211 is connected to the mainboard 10, and the mainboard 10 supplies auxiliary power to the PCIe card 1211 through the interface 1214 of the PCIe card 1211.

In this embodiment of this application, the first space 1240 of the chassis 1 is located above the second space 1210. The second space 1210 is configured to accommodate the PCIe card 1211, the PCIe card has an interface facing the first space 1240, and the interface 1214 of the PCIe card 1211 is configured to connect to a power supply wire, that is, the PCIe card 1211 supplies power in a top-powered manner. The first space 1240 is configured to accommodate the power supply wire, so that the server 100 can support the top-powered PCIe card 1211, and has strong adaptability to the PCIe card 1211.

In addition, the height of the second space 1210 is greater than or equal to 3U, that is, is greater than or equal to 133.35 mm, and an FHHL PCIe card (the height is less than or equal to 111.15 mm) and an FHFL PCIe card (the height is less than or equal to 111.15 mm) can be supported; and an HHHL PCIe card (the height is less than or equal to 68.9 mm) and an HHFL PCIe card (the height is less than or equal to 68.9 mm) can be supported. Therefore, the server 100 provided in this embodiment of this application can support a plurality of PCIe cards 1211, and has strong adaptability to the PCIe cards 1211.

For example, the plurality of PCIe cards 1211 may include a GPU card 1212, and the GPU card 1212 is located in the second space 1210. As shown in FIG. 6, the GPU card 1212, that is, the interface 1214 of the PCIe card 1211, protrudes from an upper surface of the PCIe card 1211 and extends into the first space 1240, or at least a part of the interface 1214 of the PCIe card 1211 is located in the first space 1240. It should be noted that a schematic description of a position of a structure of the GPU card 1212 in FIG. 6 does not indicate an actual shape of the structure of the GPU card. The GPU card may have a different shape from that shown in FIG. 6. This is not limited in this embodiment of this application.

Power consumption of the GPU card 1212 is large, and generally exceeds 75w, for example, 300w, 375w, or 400w. A bottom end of the GPU card 1212 is inserted into the mainboard 10, and is powered by the mainboard 10. However, a maximum power that can be provided by the mainboard 10 is 75w, and auxiliary power supply needs to be performed on the GPU card 1212 by using an auxiliary power supply structure such as the interface 1214, so as to meet a power consumption requirement of the GPU card 1212. For example, in an existing product, the interface 1214 of the consumer GPU card may be located on an upper surface of the consumer GPU card. In a top charging manner, a power supply wire of the consumer GPU card may be accommodated in the first space 1240. An interface between the data center GPU card and the workstation GPU card may be located at a tail of the data center GPU card and the workstation GPU card, that is, a rear surface of the data center GPU card and the workstation GPU card. A tail charging manner is used.

In this embodiment, the server 100 can support a consumer GPU card that uses top charging, and can also support a data center GPU card and a workstation GPU card that use tail charging, so as to support a wide variety of GPU cards such as the consumer GPU card, the data center GPU card, and the workstation GPU card, and has strong adaptability, so as to be applicable to more application scenarios and meet diversified requirements.

For example, the second space 1210 may support an active heat dissipation GPU card 1212, or may support a passive heat dissipation GPU card 1212, so that the server 100 has a relatively strong heat dissipation capability.

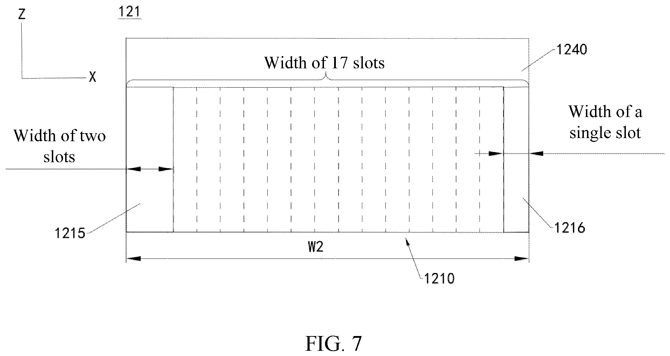

Refer to FIG. 7. FIG. 7 is a schematic diagram of regional distribution of the first space 1240 and the second space 1210 corresponding to the first area 121 shown in FIG. 3 in the width direction X.

In some embodiments, the width W of the chassis 1 is 447 mm. Accordingly, the width W2 of the second space 1210 may be greater than or equal to 312.9 mm, for example, 325.12 mm or 386.08 mm.

For example, there may be at least 17 slots in the width direction X of the second space 1210, and a single slot is 20.32 mm, that is, the width W2 of the second space 1210 may be greater than or equal to 345.44 mm. The PCIe card 1211 occupies at least one slot. In an existing product, an FHFL double-width GPU card 1215 occupies two slots, and another type of PCIe card 1216 occupies a single slot. In this embodiment of this application, another type of PCIe card may be a network adapter, an IB card, or the like, or may be a GPU card that occupies a single slot.

For example, there may be 17 slots in the width direction X of the second space 1210. In this embodiment, as shown in FIG. 7, the second space 1210 can support eight FHFL double-width GPU cards 1215, and one slot is reserved for inserting the PCIe card 1216 that occupies a single slot. Alternatively, the second space 1210 can support 17 PCIe cards 1216 that occupy a single slot.

In this embodiment, there may be at least 17 slots in the width direction X of the second space 1210, so that the server 100 provided in this embodiment of this application can support configuration of eight FHFL double-width GPU cards 1215 and one PCIe card 1216 that occupies a single slot, and have strong computing power density, so that service scenarios such as AI training and/or reasoning, HPC, and graphics rendering can be met.

In some other embodiments, the width direction X of the second space 1210 may have at most 19 slots. In this embodiment, the second space 1210 can support at least eight FHFL double-width GPU cards 1215, and three slots are reserved for inserting the PCIe card 1216 that occupies a single slot. Alternatively, the second space 1210 can support nine FHFL double-width GPU cards 1215, and one slot is reserved for inserting the PCIe card 1216 that occupies a single slot. Alternatively, the second space 1210 can support 19 PCIe cards 1216 that occupy a single slot.

In this embodiment, the server 100 provided in this embodiment of this application can support configuration of nine FHFL double-width GPU cards 1215 and one other type of PCIe card 1216, thereby further improving computing power density of the server 100.

In some other embodiments, the GPU card 1212 may further occupy three slots, four slots, or the like. This is not limited in this embodiment of this application.

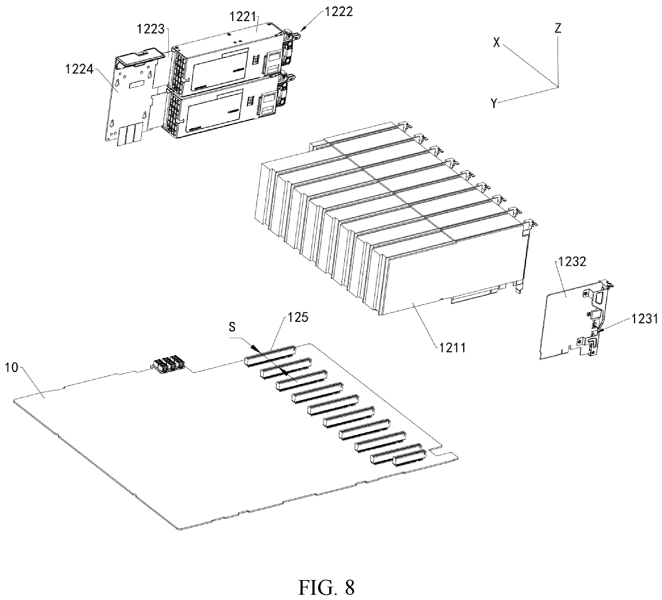

Refer to FIG. 8. FIG. 8 is a schematic exploded view of a partial structure of the server 100 shown in FIG. 2. FIG. 8 shows structures of the mainboard 10 and a partial functional component inserted into the mainboard 10.

For example, the mainboard 10 may include a plurality of PCIe sockets 125, and the plurality of PCIe sockets 125 are arranged at intervals in the width direction X of the chassis 1. The PCIe card 1211 is connected to the mainboard 10 in a manner of being inserted into the PCIe socket 125.

For example, the PCIe card 1211 may be connected to the mainboard 10 in an inline manner, so as to reduce a distance between the PCIe card 1211 and the mainboard 10, so that the first area 121 has a 4U height space, a second space 1210 of 1U can be left on the top of the first space 1240 that accommodates the PCIe card 1211, and a mounting space is provided for the interface 1214 of the PCIe card 1211 and the power supply wire, so that the server 100 supports the top-powered GPU card 1212, so as to be applicable to more application scenarios and meet diversified requirements.

In this embodiment, as shown in FIG. 6 and FIG. 8, a bottom part of the GPU card 1212 may be inserted into the mainboard 10, and is powered by the mainboard 10. A top part may be connected to the mainboard 10 through a power supply wire, and the mainboard 10 performs auxiliary power supply. Therefore, the server 100 provided in this embodiment of this application can support the GPU card 1212 that is powered by the bottom part and powered by the top part, and has strong adaptability to the GPU cards 1212.

For example, a distance S between two adjacent PCIe sockets 125 may be approximately equal to two slots, so that a sufficient space is reserved to meet a space requirement of different PCIe cards 1211, and types of PCIe cards 1211 that can be supported by the server 100 are added, so that the server 100 can meet a plurality of application scenarios and extend an applicable range, and has strong adaptability to the PCIe cards 1211. In this embodiment of this application, the distance S between the plurality of PCIe sockets 125 may be a distance between the structure centers of the two PCIe sockets in the width direction X.

The following describes, by way of example with reference to the accompanying drawings, a specific structure included in the third space 1220 corresponding to the second area 122.

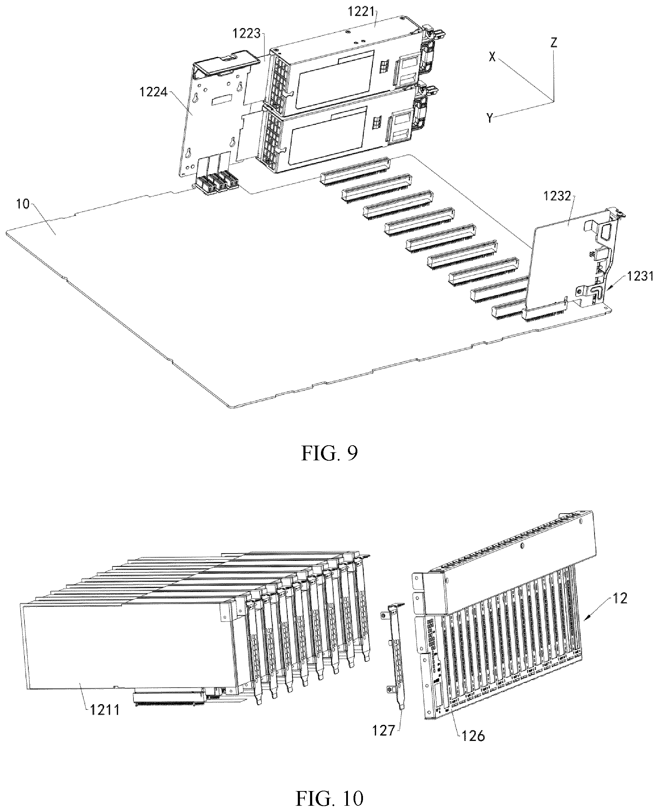

Refer to FIG. 2, FIG. 8, and FIG. 9. FIG. 9 is a schematic diagram of the partial structure shown in FIG. 8 in an assembled state. FIG. 9 shows structures of a plurality of power supply units 1221, a first adapter board 1224, and a mainboard 10 in an assembled state.

For example, the server 100 further includes a power supply unit 1221 and a first adapter board 1224, and the power supply unit 1221 is located in a third space 1220. The power supply unit 1221 is connected to the mainboard 10 through the first adapter board 1224, and is configured to supply power to the mainboard 10.

For example, the power supply unit 1221 may include a power supply interface 1222 and a pin 1223. As shown in FIG. 2, the power supply interface 1222 of the power supply unit 1221 is located on the rear panel 12, and the power supply interface 1222 of the power supply unit 1221 is configured to connect to an external power supply device and receive a current from the external power supply device. As shown in FIG. 8 and FIG. 9, the pin 1223 of the power supply unit 1221 is configured to connect to the first adapter board 1224, and the power supply unit 1221 and the first adapter board 1224 transmit a current by using the pin 1223.

In some other embodiments, the power supply unit 1221 may be directly connected to the mainboard 10, which is not limited in this embodiment of this application.

In some embodiments, as shown in FIG. 9, the first adapter board 1224 is disposed vertically relative to the mainboard 10 and is inserted into the mainboard 10. There may be a plurality of power supply units 1221. The plurality of power supply units 1221 are disposed side by side in a height direction Z of the chassis 1, and are connected to the mainboard 10 through the first adapter board 1224. The plurality of power supply units 1221 are configured to receive a current from an external power supply device of the chassis 1, and transmit the current to the mainboard 10 through the first adapter board 1224, so as to supply power to the mainboard 10.

In this embodiment, the first adapter board 1224 perpendicular to the mainboard 10 is disposed, so that the plurality of power supply units 1221 are arranged in the height direction Z of the chassis 1, thereby reducing occupation of the plurality of power supply units 1221 in the width direction X of the chassis 1, leaving more space for the second space 1210 in the width direction X, so that the second space 1210 may have a larger width, thereby accommodating more PCIe cards 1211, and improving computing power density of the server 100.

For example, as shown in FIG. 1 and FIG. 3, the third space 1220, that is, the width W3 of the second area 122, may be less than or equal to 10% of the width W of the chassis 1. In some embodiments, if the width W of the chassis 1 is 447 mm, the width W3 of the third space 1220 may be less than or equal to 44.7 mm, for example, 40.5 mm, 39 mm, or 37 mm.

In this embodiment, the plurality of power supply units 1221 in the second area 122 are arranged in the height direction Z of the chassis 1, thereby reducing occupation of the plurality of power supply units 1221 in the width direction X of the chassis 1, so that the width W3 of the third space 1220 may be less than or equal to 10% of the width W of the chassis 1.

For example, the server 100 may include two power supply units 1221. The two power supply units 1221 are arranged side by side in the height direction Z of the chassis 1. In this embodiment, two power supply units 1221 supply power to the mainboard 10 to meet a power requirement of the mainboard 10. In some other embodiments, the server 100 may further include three, five, or another quantity of power supply units 1221. This is not limited in this embodiment of this application.

For example, the first adapter board 1224 may use a circuit board of a same material as the mainboard 10, or may use a circuit board of different materials. The materials of the mainboard 10 and the first adapter board 1224 may be selected based on a requirement of a requirement specification, a high-speed signal, a flow-through capability, costs, and the like. This is not strictly limited in this embodiment of this application.

The following describes, by way of example with reference to the accompanying drawings, a specific structure included in the fourth space 1230 corresponding to the third area 123.

Refer to FIG. 2, FIG. 8, and FIG. 9. FIG. 9 further shows structures of a plurality of I/O interfaces 1231, a second adapter board 1232, and a mainboard 10 in an assembled state.

For example, the server 100 may further include a plurality of I/O interfaces 1231 and a second adapter board 1232, and the plurality of I/O interfaces 1231 are located in a fourth space 1230.

For example, the I/O interface 1231 may be one or more of a VGA interface, a USB interface, a serial port, a network port, or the like. There may be one or more interfaces, which is not limited in this embodiment of this application.

For example, as shown in FIG. 1, the I/O interface 1231 may be located on the rear panel 12, and is configured to connect to an external device of the server 100, so as to implement data transmission between the external device and the server 100.

In some embodiments, as shown in FIG. 1 and FIG. 3, the fourth space 1230, that is, the width W1 of the third area 123, may be less than or equal to 10% of the width W of the chassis 1. In some embodiments, if the width W of the chassis 1 is 447 mm, the width W1 of the fourth space 1230 may be less than or equal to 44.7 mm, for example, 40.5 mm, 39 mm, or 37 mm.

For example, as shown in FIG. 9, the second adapter board 1232 is disposed vertically relative to the mainboard 10 and is inserted into the mainboard 10. The plurality of I/O interfaces 1231 are disposed on a side of the second adapter board 1232. The plurality of I/O interfaces 1231 are disposed side by side in the height direction Z of the chassis 1, and are connected to the mainboard 10 through the second adapter board 1232. The external device is connected to the mainboard 10 through the I/O interface 1231 and the second adapter board 1232, so as to implement data transmission with the mainboard 10.

In this embodiment, the second adapter board 1232 perpendicular to the mainboard 10 is disposed, so that the plurality of I/O interfaces 1231 are arranged in the height direction Z of the chassis 1, thereby reducing occupation of the plurality of I/O interfaces 1231 in the width direction X of the chassis 1, leaving more space for the second space 1210 in the width direction X, so that the second space 1210 may have a larger width, thereby accommodating more PCIe cards 1211, and improving computing power density of the server 100.

For example, the second adapter board 1232 may use a circuit board of a same material as the mainboard 10, or may use a circuit board of a different material. The materials of the mainboard 10 and the second adapter board 1232 may be selected based on a requirement of a requirement specification, a high-speed signal, a flow-through capability, costs, and the like. This is not strictly limited in this embodiment of this application.

In some other embodiments, the fourth space 1230 corresponding to the third area 123 may also be located at a front end of the server 100, and the I/O interface 1231 may also be located on the front panel 11. This is not limited in this embodiment of this application.

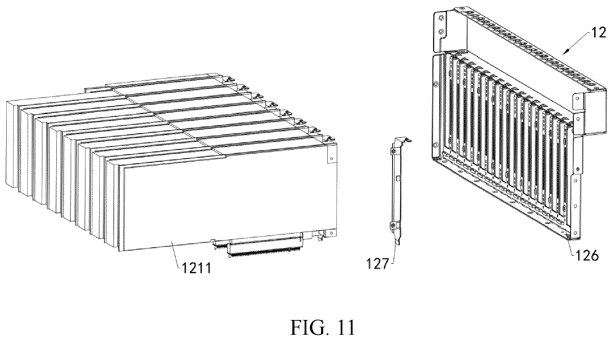

Refer to FIG. 10 and FIG. 11. FIG. 10 is a schematic exploded view of a partial structure shown in FIG. 1, and FIG. 11 is a schematic structural diagram of the structure shown in FIG. 10 from another perspective. FIG. 10 shows structures of a PCIe card 1211, a connector 127, and a fastener 126.

For example, the server 100 may further include a fastener 126, and the fastener 126 is fastened to a sidewall of the chassis 1. The fastener 126 is connected between the chassis 1 and the PCIe card 1211, and the PCIe card 1211 is fastened to the fastener 126, and is fastened to the chassis 1 through the fastener 126. This reduces a shake of the PCIe card 1211 relative to the chassis 1, and improves reliability of the PCIe card 1211.

In some embodiments, as shown in FIG. 11, the fastener 126 may be a part of the rear panel 12, and the PCIe card 1211 is fastened to the rear panel 12. In some other embodiments, the fastener 126 may also be a rigid structure with a specific mechanical strength, for example, a rod-like or panel-like metal member, plastic member, or composite material structural member. Two ends of the fastener 126 may be respectively fastened to two opposite side panels of the chassis 1, for example, a left side panel and a right side panel, so that a component fastened to the fastener 126 can be supported, and the component fastened to the fastener 126 is not shaken relative to the chassis 1.

For example, the plurality of PCIe cards 1211 are arranged in an extension direction of the fastener 126. For example, the plurality of PCIe cards 1211 may be located on a same side of the fastener 126, or may be located on both front and rear sides of the fastener 126. This is not limited in this embodiment of this application.

In some embodiments, the server 100 may further include a connector 127 that is fixedly connected between the PCIe card 1211 and the fastener 126. When the PCIe card 1211 is mounted, the connector 127 may be fastened to the PCIe card 1211, and then the connector 127 is fastened to the fastener 126, thereby implementing fastening of the PCIe card 1211.

In an existing product, different types of PCIe cards 1211 may have different structures, for example, different types of PCIe cards 1211 have different heights H. Some of the PCIe cards 1211 cannot match the fastener 126. In this embodiment, the PCIe card 1211 is fastened to the fastener 126 through the connector 127, which can resolve a problem that a structure of the PCIe card 1211 does not match the fastener 126, and cannot be directly fastened to the fastener 126. For example, a distance between the fastener 126 and the bottom panel 14 is 3U. Even if the height H of the PCIe card 1211 is less than 3U, the PCIe card 1211 may be fastened to the fastener 126 through the connector 127.

For example, there are a plurality of connectors 127. In some embodiments, the quantity of connectors 127 may be equal to the quantity of PCIe cards 1211, and a connector 127 is fixedly connected between a single PCIe card 1211 and the fastener 126. In some other embodiments, the quantity of connectors 127 may also be less than the quantity of PCIe cards 1211. For example, the PCIe cards 1211 with a same height H in the plurality of PCIe cards 1211 may be fastened to the same connector 127, and then fastened to the fastener 126 through the connector 127.

For example, a structure of the connector 127 may also be different. The structure of the connector 127 may be designed according to a structure of the PCIe card 1211, so as to match PCIe cards 1211 with different structures.

An example of a logical topology of the server 100 is described below with reference to the accompanying drawings, and a transmission path of image data in the logical topology of the server 100 is illustrated by using examples to illustrate a manner in which the server 100 implements an image processing function.

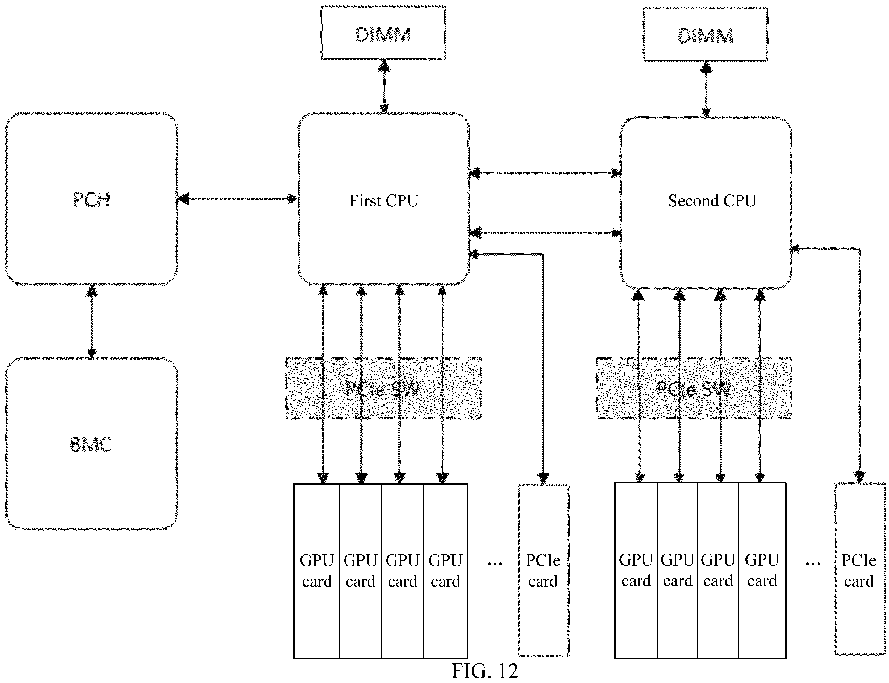

Refer to FIG. 12. FIG. 12 is a schematic diagram of a logical topology of the server 100 shown in FIG. 1 in some embodiments.

For example, the logical topology of the server 100 may include two CPUs, two DIMMs, a PCH, a BMC, two PCIe SWs, two PCIe cards, and a plurality of GPU cards.

The two CPUs may be a first CPU and a second CPU The first CPU and the second CPU are connected to each other to perform data transmission. The CPU performs data computation and saves a computation result into the hard disk. The CPU reads data from the DIMM, or may store data in the DIMM. The CPU receives a request signal from the PCH and performs related functions.

The two DIMMs are respectively connected to two CPUs, and the CPU can store data in the DIMM, or may read data from the DIMM.

The PCIe card may be a network adapter or an IB card. The PCIe card may be connected to a network to receive data from the network.

The PCH is connected to the BMC. The BMC and the PCH interact with management signals such as IPMI, USB, and VGA, to implement power-on/off, log acquisition, image display, , virtual media and the like functions.

The logical topology shown in FIG. 12 shows only a possible logical topology of the server 100. In some other embodiments, the server 100 may also include another component, and the server 100 may also have another logical topology. This is not limited in this embodiment of this application.

The following exemplifies a transmission path of image information in the logical topology of the server 100 according to the logical topology shown in the accompanying drawings, to illustrate a manner in which the server 100 implements an image processing function.

For example, the server 100 may implement an image processing function by using a PCIe card, a CPU, a DIMM, and a GPU card. The PCIe card stores the received image data into the memory by using the first CPU. The GPU card reads image data from the DIMM through the PCIe link, performs computation on the image data, and stores a computation result into a hard disk, so as to implement an image processing function of the server 100.

In some other embodiments, the image data may be transmitted in another component, or may have another transmission path. This is not limited in this embodiment of this application.

The foregoing descriptions are merely specific implementations of embodiments of this application, but are not intended to limit the protection scope of embodiments of this application. Any variation or replacement readily figured out by a person skilled in the art within the technical scope disclosed in embodiments of this application shall fall within the protection scope of embodiments of this application. When no conflict occurs, embodiments of this application and the features in the embodiments may be mutually combined. Therefore, the protection scope of embodiments of this application shall be subject to the protection scope of the claims.

## Claims

1. A server, comprising a chassis and a plurality of PCIe cards, wherein an internal space of the chassis comprises a first space and a second space that are arranged in a height direction, the first space is located above the second space, the PCIe cards are located in the second space, at least one of the PCIe cards has an interface facing the first space, the interface of the PCIe card is configured to connect to a power supply wire, the first space is configured to accommodate the power supply wire, a height of the second space is greater than or equal to 3U, and a height of the chassis is greater than or equal to 4U.

2. The server according to claim 1, wherein the interface of the PCIe card protrudes from an upper surface of the PCIe card and extends into the first space.

3. The server according to claim 1, wherein the server further comprises a mainboard, the mainboard is fastened to a bottom panel of the chassis, and the PCIe card is inserted into the mainboard.

4. The server according to claim 1, wherein there are at least 17 slots in a width direction of the second space, and the PCIe card occupies at least one of the slots.

5. The server according to claim 4, wherein there are at most 19 slots in the width direction of the second space.

6. The server according to claim 4, wherein the plurality of PCIe cards comprise at least eight FHFL double-width GPU cards, and each of the FHFL double-width GPU cards occupies two of the slots.

7. The server according to any one of claims 3 to 6, wherein the server further comprises a power supply unit, the internal space of the chassis further comprises a third space, the third space is parallel to the second space in a horizontal direction, and the power supply unit is located in the third space.

8. The server according to claim 7, wherein the third space is located on a left side or a right side of the second space; or the second space comprises at least two subspaces, and the third space is located between two of the subspaces.

9. The server according to claim 7, wherein the server further comprises a first adapter board, and there are a plurality of power supply units; and the plurality of power supply units are disposed side by side in the height direction of the chassis and are connected to the mainboard through the first adapter board.

10. The server according to claim 9, wherein the server further comprises an I/O interface, the internal space of the chassis further comprises a fourth space, the fourth space is parallel to the second space in the horizontal direction, and the I/O interface is located in the fourth space.

11. The server according to claim 10, wherein the server further comprises a second adapter board, and there are a plurality of I/O interfaces; and the plurality of I/O interfaces are disposed side by side in the height direction of the chassis, and are connected to the mainboard through the second adapter board.

12. A data center, comprising a plurality of servers according to any one of claims 1 to 11.
